# EUROPÄISCHE PATENTSCHRIFT

(11) **EP 2 878 929 B1**
(45) Veröffentlichungstag und Bekanntmachung des Hinweises auf die Patenterteilung: **09.11.2016**
(21) Anmeldenummer: 14183489.5
(22) Anmeldetag: 04.09.2014
(51) Int. Cl.: G01D 5/245

(54) **Multiturn-Drehgeber**
Multi-turn rotary encoder
Encodeur à plusieurs rotations

(30) Priorität: 28.11.2013 DE 102013224375
(43) Veröffentlichungstag der Anmeldung: 03.06.2015
(73) Patentinhaber: Dr. Johannes Heidenhain GmbH, 83301 Traunreut (DE)
(72) Erfinder: Von Berg, Martin, 83236 Übersee (DE)

(56) Entgegenhaltungen:
- EP-A1- 1 617 180
- EP-A2- 1 770 372
- WO-A1-2011/042190
- DE-A1-102008 015 837
- US-A1- 2010 078 468

## Beschreibung

### GEBIET DER TECHNIK

Die Erfindung betrifft einen sicheren Multiturn-Drehgeber gemäß dem Anspruch 1, sowie ein Verfahren zum Betreiben eines derartigen Multiturn-Drehgebers nach Anspruch 8. Multiturn-Drehgeber werden häufig in der Automatisierungstechnik eingesetzt, um die Winkelpositionen und die Anzahl zurückgelegter Umdrehungen von Wellen zu messen.

### STAND DER TECHNIK

Positionsmesseinrichtungen zur Messung der Winkelposition einer Welle sind aus einer Vielzahl von Druckschriften bekannt. Derartige Positionsmesseinrichtungen werden als Drehgeber bezeichnet. Ist eine Positionsmesseinrichtung darüber hinaus so ausgeführt, dass neben der Winkelposition der Welle auch die Anzahl der von der Welle zurückgelegten Umdrehungen messbar ist, spricht man von einem Multiturn-Drehgeber.

Für die Ausführung der Multiturn-Einheit, also der Einheit zur Feststellung der Anzahl der zurückgelegten Umdrehungen der Welle sind grundsätzlich zwei Lösungen bekannt, zum einen getriebebasierte Multiturn-Einheiten, zum anderen zählerbasierte Multiturn-Einheiten.

Zählerbasierte Multiturn-Einheiten ermitteln die Anzahl zurückgelegter Umdrehungen einer Welle durch Zählen der Umdrehungen eines Codeträgers, der unmittelbar von der Welle angetrieben wird und somit die gleiche Anzahl von Umdrehungen wie die zu messende Welle zurücklegt. Auf dem Codeträger ist ein Code angeordnet, der von einer Abtasteinheit abgetastet wird. Aus den mit der Abtasteinheit ermittelten Positionssignalen werden in einer Zählelektronik Zählsignale für einen Zähler generiert, der die Anzahl vollständiger Umdrehungen des Codeträgers und somit der Welle drehrichtungsabhängig zählt.

Um den Zählerstand des Zählers auch bei ausgeschalteter Hauptstromversorgung, also beispielsweise wenn die Maschine, in der der Multiturn-Drehgeber betrieben wird, ausgeschaltet ist, zu speichern und darüber hinaus die Zählfunktion zu erhalten, sind zählerbasierte Multiturn-Einheiten häufig mit einer Batterie ausgestattet, die bei Ausfall der Hauptstromversorgung die Energieversorgung zumindest der Muititurn-Einheit des Drehgebers übernimmt.

Die EP 1 462 771 B1 beschreibt beispielsweise einen Multiturn-Drehgeber mit einer zählerbasierten Muititurn-Einheit, die im ausgeschalteten Zustand mit einer Batterie betrieben ist.

Die DE 10 2008 015 837 A1 beschreibt ein Positionsmessgerät basierend auf einem induktiven Abtastprinzip, das einen Batteriebetrieb aufweist. Auch dieses Positionsmessgerät ist gut geeignet, als Multiturn-Drehgeber ausgeführt zu werden.

Die EP 1 617 180 A1 beschreibt ebenfalls einen Multiturn-Drehgeber mit Batteriebetrieb, wobei der Ladezustand der Batterie mit einer Überwachungseinheit überwacht wird.

Multiturn-Drehgeber betrieben wird, führen kann oder sogar eine Gefahr für das Bedienpersonal der Maschine entstehen kann.

Die DE 10 2009 029 431 A1 schlägt deshalb einen Multiturn-Drehgeber vor, der mit zwei voneinander unabhängigen Multiturn-Einheiten ausgestattet ist. Ein Vergleich der Messwerte der Multiturn-Einheiten ermöglicht zu jeder Zeit eine Überprüfung der Funktionsfähigkeit des Multiturn-Drehgebers. Dieser ist somit für den Einsatz in sicherheitsrelevanten Applikationen geeignet.

Kommen bei einem solchen Multiturn-Drehgeber jedoch zwei zählerbasierte Multiturn-Einheiten zum Einsatz, die für den Betrieb im ausgeschalteten Zustand von einer Batterie mit Energie versorgt werden, so kann es dennoch in seltenen Fällen zu Fehlerzuständen kommen, die sich auf beide Multiturn-Einheiten gleich auswirken und daher nicht unmittelbar entdeckt werden können.

### ZUSAMMENFASSUNG DER ERFINDUNG

Es ist eine Aufgabe der Erfindung, einen Multiturn-Drehgeber mit verbesserter Betriebssicherheit anzugeben. Weiter ist es Aufgabe der Erfindung, ein Verfahren zum Betreiben eines derartigen Multiturn-Drehgebers anzugeben.

Der erste Teil der Aufgabe wird gelöst durch einen Multiturn-Drehgeber nach Anspruch 1.

Es wird ein Multiturn-Drehgeber mit
- einer Maßverkörperung mit mindestens einer Teilungsspur, mittels derer die Winkelstellung einer Welle absolut codiert ist,
- einer ersten Abtasteinrichtung, mit der die wenigstens eine Teilungsspur zur Erzeugung von ersten Positionssignalen abtastbar ist,
- einer ersten Singleturn-Auswerteeinheit zur Bildung eines ersten Singleturn-Codeworts aus den ersten Positionssignalen,

Auch die WO 2011/042190 A1 beschreibt einen Multiturn-Drehgeber mit Batteriebetrieb. Hier ist darüber hinaus vorgesehen, den Multiturn-Drehgeber im Batteriebetrieb gepulst zu betreiben.

Die US 2010/0078468 A1 offenbart ebenfalls einen Multiturn-Drehgeber, der sowohl von einer externen, als auch von einer internen Stromversorgung betrieben werden kann.

Aus sicherheitstechnischen Gründen kann es erforderlich sein, die Anzahl der Umdrehungen einer Welle redundant zu messen, beispielsweise dann, wenn eine Fehlmessung zu einer Beschädigung Maschine, an der der Multiturn-Drehgeber betrieben wird, führen kann oder sogar eine Gefahr für das Bedienpersonal der Maschine entstehen kann.

Die DE 10 2009 029 431 A1 schlägt deshalb einen Multiturn-Drehgeber vor, der mit zwei voneinander unabhängigen Multiturn-Einheiten ausgestattet ist. Ein Vergleich der Messwerte der Multiturn-Einheiten ermöglicht zu jeder Zeit eine Überprüfung der Funktionsfähigkeit des Multiturn-Drehgebers. Dieser ist somit für den Einsatz in sicherheitsrelevanten Applikationen geeignet.

Kommen bei einem solchen Multiturn-Drehgeber jedoch zwei zählerbasierte llllultiturn-Einheiten zum Einsatz, die für den Betrieb im ausgeschalteten Zustand von einer Batterie mit Energie versorgt werden, so kann es dennoch in seltenen Fällen zu Fehlerzuständen kommen, die sich auf beide Multiturn-Einheiten gleich auswirken und daher nicht unmittelbar entdeckt werden können.

### ZUSAMMENFASSUNG DER ERFINDUNG

Es ist eine Aufgabe der Erfindung, einen Multiturn-Drehgeber mit verbesserter Betriebssicherheit anzugeben. Weiter ist es Aufgabe der Erfindung, ein Verfahren zum Betreiben eines derartigen Multiturn-Drehgebers anzugeben.

Der erste Teil der Aufgabe wird gelöst durch einen Multiturn-Drehgeber nach Anspruch 1.

Es wird ein Multiturn-Drehgeber mit
- einer Maßverkörperung mit mindestens einer Teilungsspur, mittels derer die Winkelstellung einer Welle absolut codiert ist,
- einer ersten Abtasteinrichtung, mit der die wenigstens eine Teilungsspur zur Erzeugung von ersten Positionssignalen abtastbar ist,
- einer ersten Singleturn-Auswerteeinheit zur Bildung eines ersten Singleturn-Codeworts aus den ersten Positionssignalen,
- einer ersten Multiturn-Auswerteeinheit zur Bildung eines ersten Multiturn-Codeworts aus den ersten Positionssignalen,
- einer zweiten Abtasteinrichtung, mit der die wenigstens eine Teilungsspur zur Erzeugung von zweiten Positionssignalen abtastbar ist,
- einer zweiten Singleturn-Auswerteeinheit zur Bildung eines zweiten Singleturn-Codeworts aus den zweiten Positionssignalen,
- einer zweiten Multiturn-Auswerteeinheit zur Bildung eines zweiten Multiturn-Codeworts aus den zweiten Positionssignalen,
- einer Batterie, mit der wenigstens die zur Bildung der Multiturn-Codewörter erforderlichen Komponenten bei Ausfall einer Hauptstromversorgung mit Energie versorgbar sind,
vorgeschlagen, der eine erste Batterie-Überwachungseinheit umfasst, mit der die Funktion der Batterie überwachbar und durch wenigstens ein Batterie-Zustandssignal anzeigbar ist.

Der zweite Teil der Aufgabe wird gelöst durch ein Verfahren zum Betreiben eines Multiturn-Drehgebers nach Anspruch 9.

Hier wird ein Verfahren zum Betreiben eines Multiturn-Drehgebers mit
- einer Maßverkörperung mit mindestens einer Teilungsspur, mittels derer die Winkelstellung einer Welle absolut codiert ist,
- einer ersten Abtasteinrichtung, mit der die wenigstens eine Teilungsspur zur Erzeugung von ersten Positionssignalen abtastbar ist,
- einer ersten Singleturn-Auswerteeinheit zur Bildung eines ersten Singleturn-Codeworts aus den ersten Positionssignalen,
- einer ersten Multiturn-Auswerteeinheit zur Bildung eines ersten Multiturn-Codeworts aus den ersten Positionssignalen,
- einer zweiten Abtasteinrichtung, mit der die wenigstens eine Teilungsspur zur Erzeugung von zweiten Positionssignalen abtastbar ist,
- einer zweiten Singleturn-Auswerteeinheit zur Bildung eines zweiten Singleturn-Codeworts aus den zweiten Positionssignalen,
- einer zweiten Multiturn-Auswerteeinheit zur Bildung eines zweiten Multiturn-Codeworts aus den zweiten Positionssignalen,
- einer Batterie, mit der wenigstens die zur Bildung der Multiturn-Codewörter erforderlichen Komponenten bei Ausfall einer Hauptstromversorgung mit Energie versorgbar sind,
vorgeschlagen, wobei die Funktion der Batterie mit einer erste Batterie-Überwachungseinheit überwacht und durch wenigstens ein Batterie-Zustandssignal angezeigt wird.

Weitere Vorteile eines erfindungsgemäßen Multiturn-Drehgebers, sowie eines erfindungsgemäßen Verfahrens zum Betreiben eines derartigen Multiturn-Drehgebers, ergeben sich aus der nachfolgenden Beschreibung der Ausführungsformen.

### KURZE BESCHREIBUNG DER ZEICHNUNGEN

Es zeigt
- Figur 1: ein Blockschaltbild eines erfindungsgemäßen Multiturn-Drehgebers,
- Figur 2: ein Prinzipschaltbild einer Ladezustands-Überwachungseinheit und
- Figur 3: ein Prinzipschaltbild einer Kontinuitäts-Überwachungseinheit.

### BESCHREIBUNG DER AUSFÜHRUNGSFORMEN

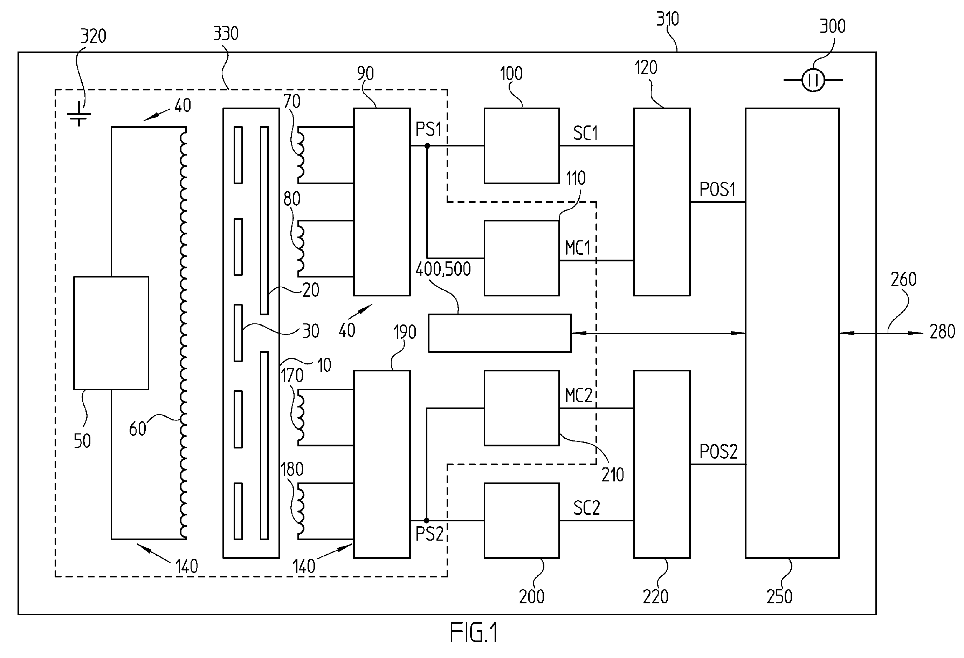

In Figur 1 zeigt ein Blockschaltbild eines erfindungsgemäßen Multiturn-Drehgebers. Er basiert auf einem induktiven Abtastprinzip, wie es beispielsweise in der DE 10 2008 015 837 A1 beschrieben ist, auf die an dieser Stelle explizit verwiesen wird.

Dennoch sei ausdrücklich darauf hingewiesen, dass die vorliegende Erfindung nicht auf das physikalische Abtastprinzip festgelegt ist. So können beispielsweise auch lichtelektrische, magnetische oder kapazitive Abtastprinzipien zum Einsatz kommen.

Der Multiturn-Drehgeber weist eine Maßverkörperung 10 mit mindestens einer Teilungsspur auf, mittels derer die Winkelstellung eine Welle absolut codiert ist. Die Maßverkörperung 10 im dargestellten Beispiel umfasst zwei Teilungsspuren 20, 30, wobei Maßverkörperung 10 und Teilungspuren 20, 30 lediglich abstrakt vereinfacht dargestellt sind. In einer tatsächlichen Realisierung kann die Maßverkörperung 10 beispielsweise als Codescheibe ausgeführt sein, die drehfest mit der Welle, deren Winkelposition/Umdrehungszahl zu messen ist, verbunden ist. Die Teilungsspuren 20, 30 können aus elektrisch leitfähigen und nicht leitfähigen Bereichen bestehen, die konzentrisch um den Drehmittelpunkt der Codescheibe auf verschiedenen Radien angeordnet sind.

Die zu messende Winkelposition ist in diesem Beispiel analog codiert, d.h. bei der Abtastung der Teilungsspuren 20, 30 entstehen analoge Abtastsignale, aus deren Amplituden und/oder Phasenlagen die Winkelposition der Eingangswelle W bestimmt werden kann. Alternativ hierzu kann die Winkelposition aber auch digital codiert sein, beispielsweise indem die Teilungsspuren einen mehrspurigen digitalen Code, z.B. einen Gray-Code, oder einen einspurigen Kettencode, einem sog. "Pseudo Random Code" (PRC) aufweisen. Eine digitale Codierung wird beispielsweise bei lichtelektrischen Abtastprinzipien bevorzugt eingesetzt.

Zur Erzeugung erster Positionssignale PS1 ist nun eine erste Abtasteinrichtung 40 vorgesehen. Sie umfasst eine Erregereinheit 50, die in Verbindung mit einer Erregerspule 60 ein elektromagnetisches Feld erzeugt, dessen Stärke von den Teilungsspuren 20, 30 beeinflusst wird. Zur Detektion des elektromagnetischen Feldes sind zwei Paare von ersten Empfängerspulen 70, 80 vorgesehen, wobei jedes Paar Empfängerspulen 70, 80 zueinander phasenverschobene Positionssignale generiert, die eine drehrichtungsabhängige Positionserfassung ermöglichen. Dabei dient das erste Empfängerspulenpaar 70 der Abtastung der ersten Teilungsspur 20 und das zweite Empfängerspulenpaar 80 der Abtastung der zweiten Teilungsspur 30. In den Empfängerspulen 70, 80 werden im Betrieb Spannungen induziert, deren Amplitude von der Winkelstellung der Codescheibe, bzw. der zu messenden Welle abhängt. Die induzierten Spannungen sind einer ersten Signalverarbeitungseinheit 90 zugeführt, in der sie beispielsweise gefiltert und verstärkt werden, bevor sie als erste Positionssignale PS1 zum Einen an eine erste Singleturn-Auswerteeinheit 100 und zum Anderen an eine erste Multiturn-Auswerteeinheit 110 ausgegeben werden.

Die erste Singleturn-Auswerteeinheit 100 verarbeitet die ersten Positionssignale PS1 zu einem ersten Singleturn-Codewort SC1, das die Winkelposition der zu messenden Welle angibt.

Die erste Multiturn-Auswerteeinheit 110 dagegen verarbeitet die ersten Positionssignale PS1 zu einem ersten Multiturn-Codewort MC1, das die Anzahl der von der zu messenden Welle zurückgelegten Umdrehungen angibt. Die erste Multiturn-Auswerteinheit 110 kann hierzu beispielsweise einen Zähler umfassen, der geeignete Ereignisse der ersten Positionssignale PS1 drehrichtungsabhängig zählt.

Der Nullpunkt der Messung kann manuell festgelegt werden oder beispielsweise durch Erreichen eines Endschalters o.ä. Zum Einstellen des Nullpunkts, von dem aus die Zählung der Umdrehungen beginnt, ist es meist notwendig, vor dem eigentlichen Betrieb der Maschine eine sog. Referenzfahrt vorzunehmen.

Das erste Singleturn-Codewort SC1 und das erste Multiturn-Codewort MC1 sind schließlich einer ersten Codeanschlusseinheit 120 zugeführt, die aus den beiden Werten einen gemeinsamen ersten Positionswert POS1 bildet, der sowohl die aktuelle Winkelposition, als auch die Anzahl der zurückgelegten Umdrehungen beeinhaltet.

Zur Bildung eines redundanten zweiten Positionswerts POS2 sind, mit Ausnahme der Erregereinheit 50 mit der Erregerspule 60, alle genannten Einheiten identisch ein zweites Mal vorhanden.

Somit ist zur Bildung zweiter Positionssignale PS2 eine zweite Abtasteinrichtung 140 vorgesehen. Dieser sind ebenfalls die Erregereinheit 50 und die Erregerspule 60, die zusammen das elektromagnetische Feld erzeugen, zugeordnet. Zur Detektion des von den Teilungsspuren 20, 30 modulierten elektromagnetischen Feldes sind zwei Paare von zweiten Empfängerspulen 170, 180 vorgesehen, wobei jedes Paar Empfängerspulen 170, 180 zueinander phasenverschobene Positionssignale generiert, die eine drehrichtungsabhängige Positionserfassung ermöglichen. Dabei dient das erste Empfängerspulenpaar 170 der Abtastung der ersten Teilungsspur 20 und das zweite Empfängerspulenpaar 180 der Abtastung der zweiten Teilungsspur 30. Eine zweite Signalverarbeitungseinheit 190 verarbeitet die induzierten Spannungen zu zweiten Positionssignalen PS2.

Neben der Erregereinheit 50 und der Erregerspule 60, die sie mit der ersten Abtasteinrichtung 40 teilt, umfasst die zweite Abtasteinrichtung somit die zweiten Empfängerspulen 170, 180 und die zweite Signalverarbeitungseinheit 190.

Die zweiten Positionssignale PS2 sind einer zweiten Singleturn-Auswerteeinheit 200 zur Bildung eines zweiten Singleturn-Codeworts SC2 und einer zweiten Multiturn-Auswerteeinheit 210 zur Bildung eines zweiten Multiturn-Codeworts MC2 zugeführt. Eine zweite Codeanschlusseinheit 220 bildet schließlich aus dem zweiten Singleturn-Codewort SC2 und dem zweiten Multiturn-Codewort MC2 den zweiten Positionswert POS2.

Zur Kommunikation mit einer (nicht dargestellten) Folgeelektronik 280 ist eine Schnittstelleneinheit 250 vorgesehen, die Befehle und Daten von der Folgeelektronik 280 über einen Datenübertragungskanal 260 empfängt, bzw. Daten (in Folge von empfangenen Befehlen) an die Folgeelektronik 280 sendet. Die Schnittstelleneinheit 250 kann als serielle Schnittstelle ausgeführt sein, d.h. die Datenübertragung über den Datenübertragungskanal 260 erfolgt in Form von seriellen Datenströmen, ggf. synchronisiert durch ein Taktsignal.

Der Schnittstelleneinheit 250 sind in diesem Beispiel die Positionswerte POS1, POS2 zugeführt und können, beispielsweise in Folge eines Positionsanforderungsbefehls, zur Folgeelektronik 280 übertragen werden. Alternativ können die Multiturn-Codeworte MC1, MC2 und die Singleturn-Codeworte SC1, SC2 zur separaten Übertragung an die Folgeelektronik 280 auch direkt der Schnittstelleneinheit 250 zugeführt sein. In diesem Fall kann ggf. auf die Codeanschlusseinheiten 120, 220 verzichtet werden

Im Normalbetrieb werden alle Komponenten, die zur Bildung der Positionswerte POS1, POS2 und zur Kommunikation mit der Folgeelektronik 280 erforderlich sind, von einer Hauptstromversorgung 300 mit Energie versorgt. In Figur 1 betrifft das alle Komponenten, die sich im Bereich 310 befinden.

Um bei einem Ausfall der Hauptstromversorgung 300 weiterhin die Multiturn-Codewörter MC1, MC2 speichern und eine Zählung zurückgelegter Umdrehungen vornehmen zu können, werden die dazu benötigten Komponenten in einem batteriegestützten Bereich 330 von einer Batterie 320 mit Energie versorgt. Die Umschaltung vom Normalbetrieb mit Versorgung durch die Hauptstromversorgung 300 zum Batteriebetrieb mit Versorgung des batteriegestützten Bereichs 330 durch die Batterie 320 und umgekehrt erfolgt mit Vorteil automatisch bei Unter/-Überschreiten eines Minimalwerts der Ausgangsspannung V+ der Hauptstromversorgung 300.

Dadurch, dass bei einem erfindungsgemäßen Multiturn-Drehgeber zwei Multiturn-Codewörter MC1, MC2 weitgehend unabhängig voneinander erzeugt werden, wird bereits eine hohe Betriebssicherheit erreicht. Um die Wahrscheinlichkeit, eine Fehlfunktion bei der Erzeugung der Multiturn-Codewörter MC1, MC2 insbesondere bei Batteriebetrieb zu erkennen, weiter zu erhöhen, ist nun erfindungsgemäß im Multiturn-Drehgeber eine erste Batterie-Überwachungseinheit 400 vorgesehen, die die Funktion der Batterie überwacht und der Schnittstelleneinheit durch wenigstens ein Batterie-Zustandssignal anzeigt. Dadurch kann der Folgeelektronik 280 beispielsweise ein Ausfall (oder ein bevorstehender Ausfall) der Batterie angezeigt werden.

Um noch höheren Sicherheitsanforderungen zu genügen, ist mit Vorteil eine redundante zweite Batterie-Überwachungseinheit 500 vorgesehen.

Die ordnungsgemäße Funktion der Batterie ist zum Einen dann gegeben, wenn sie einen ausreichenden Ladezustand aufweist, d.h. die Batteriespannung V_{BAT} einen minimalen Wert, der für die Funktion benötigt wird, erreicht. Zum Anderen ist es auch notwendig, dass die Batteriespannung V_{BAT} im Batteriebetrieb kontinuierlich anliegt, da jede auch nur kurzzeitige Unterbrechung oder Unterschreitung der minimal für den Betrieb notwendigen Spannung ein Löschen der Multiturn-Codewörter MC1, MC2 bedeuten kann, da die entsprechenden Bauteile (Zähler, etc.) nicht oder nur ungenügend mit Energie versorgt werden. Eine Unterbrechung tritt beispielsweise dann auf, wenn bei ausgeschalteter Maschine die Batterie 320 unsachgemäß ausgetauscht wird.

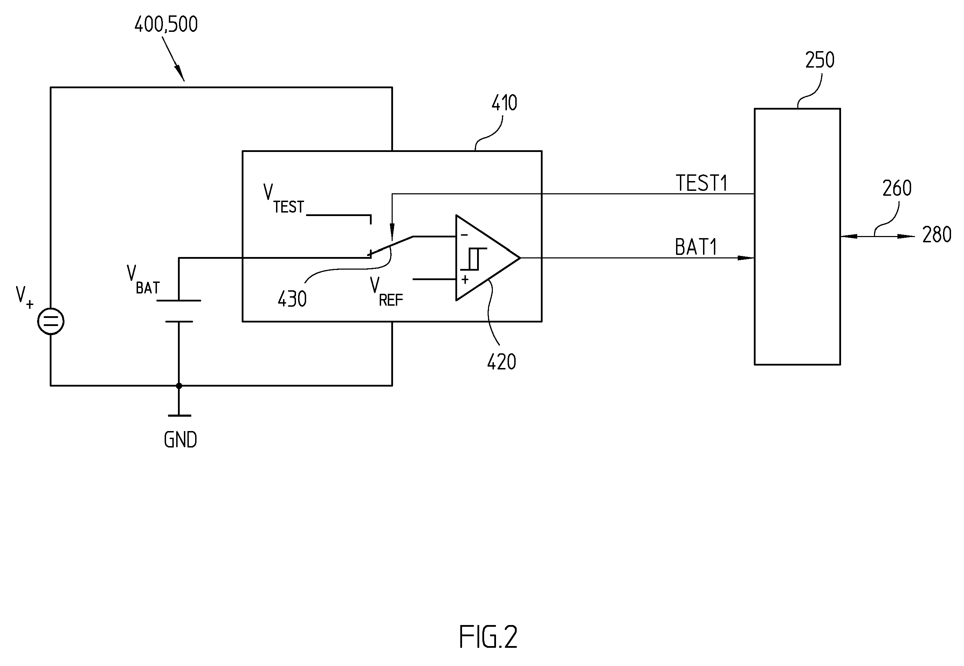

Zur Feststellung, ob der Ladezustand der Batterie den Anforderungen genügt, ist in der ersten Batterie-Überwachungseinheit eine Ladezustands-Überwachungseinheit 410 angeordnet. Figur 2 zeigt beispielhaft ein Prinzipschaltbild einer Ladezustands-Überwachungseinheit 410.

Der Ladezustands-Überwachungseinheit 410 ist die Batteriespannung V_{BAT} zugeführt. Sie ist geeignet ausgestaltet um, beispielsweise durch Vergleich der Batteriespannung V_{BAT} mit einer Referenzspannung V_{REF}, festzustellen, ob die Batteriespannung V_{BAT} den geforderten Minimalwert erreicht. Das Ergebnis des Vergleichs gibt die Ladezustands-Überwachungseinheit 410 als erstes Batterie-Zustandssignal BAT1 aus. Der Vergleich wird in einer Vergleichereinheit 420 ausgeführt, die ein einfacher Komparatorbaustein sein kann.

Das erste Batterie-Zustandssignal BAT1 ist der Schnittstelleneinheit 250 zugeführt und kann von dort zur Folgeelektronik 280 übertragen werden. Dies kann auf direkte Anfrage per Befehl, oder automatisch als Teil eines Datenpakets erfolgen, das auch die Positionsdaten POS1, POS2 enthält.

Die Ladezustands-Überwachungseinheit 410 kann auch mehrere Vergleichereinheiten 420 umfassen, so dass z.B. durch Vergleich der Batteriespannung V_{BAT} mit einer für den Betrieb gerade noch zulässigen Spannung ein weiteres Batterie-Zustandssignal erzeugt werden kann, das als Ausfall-Warnung zu interpretieren ist, so dass vor einem tatsächlichen Ausfall ein Batterietausch vorgenommen werden kann.

Da eine niedrige Batteriespannung V_{BAT} normalerweise einen statischen Zustand der Batterie 320 darstellt, wird die Ladezustands-Überwachungseinheit 410 von der Hauptstromversorgung 300 mit Energie versorgt.

Um gewährleisten zu können, dass der Wert des ersten Batterie-Zustandssignals V_{BAT} durch einen tatsächlichen Spannungsvergleich und nicht etwa durch eine Fehlfunktion beispielsweise der Vergleichereinheit 420 zustande kommt, ist in der Ladezustands-Überwachungseinheit 410 weiter ein erstes Schaltelement 430 angeordnet, das, gesteuert durch ein erstes Testsignal TEST1, die zu überprüfende Spannung am Eingang der Vergleichereinheit 420 von der Batteriespannung V_{BAT} zu einer Testspannung V_{TEST} umschaltet. Die Testspannung V_{TEST} ist so gewählt, dass die Vergleichereinheit 420 einen zu niedrigen Ladestand der Batterie 320 erkennen und mit Hilfe des ersten Batterie-Zustandssignals BAT1 signalisieren muss. Auf diese Weise wird ein zu niedriger Ladezustand der Batterie 320 künstlich verursacht und die Funktion der Ladezustands-Überwachungseinheit 410 kann überprüft werden. Das Testsignal TEST1 kann beispielsweise durch Befehle der Folgeelektronik 280, die über den Datenübertragungskanal 260 an die Schnittstelleneinheit 250 des Multiturn-Drehgebers gesendet werden, gesteuert werden.

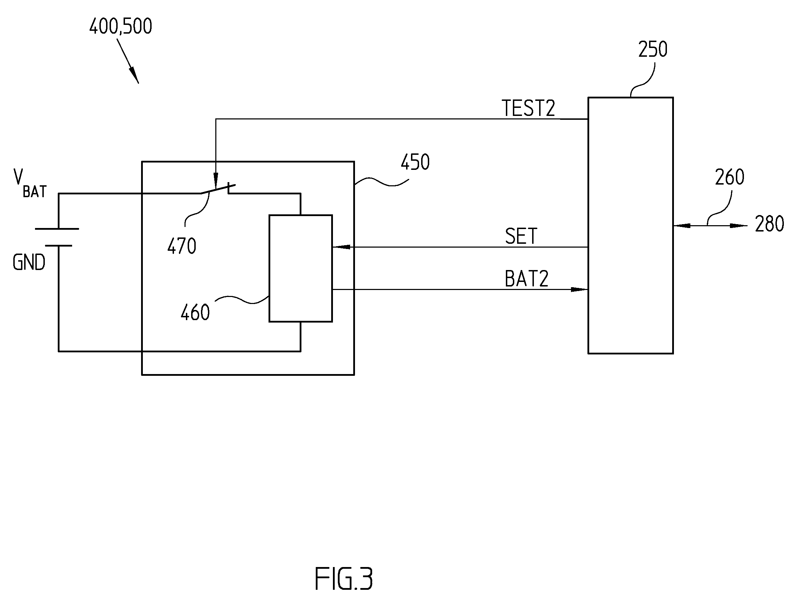

Zur Prüfung der Kontinuität der Batteriespannung V_{BAT} umfasst die erste Batterie-Überwachungseinheit 400 eine Kontinuitäts-Überwachungseinheit 450, die geeignet ausgestaltet ist, um zumindest bei ausgeschalteter Hauptstromversorgung 300, also im Batteriebetrieb, ein kurzzeitiges Wegfallen (z.B. bei einem Batteriewechsel), sowie ggf. ein Unterschreiten einer minimal zum sicheren Betrieb notwendigen Spannung, festzustellen und mit einem zweiten Batterie-Zustandssignal BAT2 anzuzeigen. Figur 3 zeigt ein Prinzipschaltbild einer derartigen Einheit.

Die Kontinuitäts-Überwachungseinheit 450 enthält nun eine Speichereinheit 460, die von der Batteriespannung V_{BAT} gespeist wird. Die Speichereinheit 460 kann bei eingeschalteter Hauptstromversorgung 300 über ein Setzsignal SET auf einen definierten Wert programmiert werden, der sich in Folge einer Diskontinuität der Batteriespannung V_{BAT} verändert.

In einer sehr einfachen Ausführung umfasst die Speichereinheit 460 einen Flipflop-Baustein (z.B. D-Flipflop), der mit dem Setzsignal SET (per Befehl von der Folgeelektronik 280) auf einen definierten logischen Pegel, z.B. einen Highpegel, programmiert werden kann. Der Highpegel wird als zweites Batterie-Zustandssignal BAT2 (beispielsweise an die Schnittstelleneinheit 250) ausgegeben und signalisiert einen fehlerfreien Betrieb. Entfällt nun die Batteriespannung V_{BAT} (beispielsweise durch Entnehmen der Batterie 320), oder sinkt unter einen Schwellwert, so wird der logische Highpegel gelöscht (Rücksetzen des Flipflop-Bausteins). Erreicht nun die Batteriespannung V_{BAT} wieder den für den Betrieb erforderlichen Wert, so bleibt der Flipflop-Baustein zurückgesetzt und die aufgetretene Diskontinuität der Batteriespannung V_{BAT} wird von Speichereinheit 460 als logischer Lowpegel durch das zweite Batterie-Zustandssignal BAT2 angezeigt. Für die Überwachung der Batteriespannung V_{BAT} und zum Herstellen eines definierten Zustands (im obigen Beispiel das explizite Setzen des zweiten Batterie-Zustandssignals BAT2 auf logischen Lowpegel), nachdem die Batteriespannung V_{BAT} wieder den erforderlichen Wert erreicht hat, kann in der Speichereinheit 460 ein Reset-Baustein vorgesehen sein.

Auch in der Kontinuitäts-Überwachungseinheit 450 ist eine Möglichkeit vorgesehen, eine Diskontinuität der Batteriespannung V_{BAT} künstlich zu verursachen, nämlich mit Hilfe eines zweiten Schaltelements 470, das von einem zweiten Testsignal TEST2 gesteuert werden kann. Ein Öffnen des zweiten Schaltelements 470 unterbricht nun die Verbindung der Batteriespannung V_{BAT} mit der Speichereinheit 460 und erzwingt so ein Löschen der Speichereinheit 460. Das zweite Testsignal TEST2 kann wiederum von der Folgeelektronik 280 gesteuert werden. Anstelle einer Unterbrechung kann auch hier vorgesehen sein, dass das Schalten des zweiten Schaltelements 470 eine Umschaltung von der Batteriespannung V_{BAT} auf eine Testspannung vornimmt, deren Spannung unterhalb des Wertes liegt, bei dem eine Löschung der Speichereinheit 460 erfolgt.

Selbstverständlich ist die vorliegende Erfindung nicht auf die beschriebenen Ausführungsbeispiele eingeschränkt. Vielmehr ist ein Fachmann dazu in der Lage, im Rahmen der Ansprüche alternative Ausführungsformen zu gestalten.

## Patentansprüche

1. Multiturn-Drehgeber mit
- einer Maßverkörperung (10) mit mindestens einer Teilungsspur (20, 30), mittels derer die Winkelstellung einer Welle absolut codiert ist,
- einer ersten Abtasteinrichtung (40), mit der die wenigstens eine Teilungsspur (20, 30) zur Erzeugung von ersten Positionssignalen (PS1) abtastbar ist,
- einer ersten Singleturn-Auswerteeinheit (100) zur Bildung eines ersten Singleturn-Codeworts (SC1) aus den ersten Positionssignalen (PS1),
- einer ersten Multiturn-Auswerteeinheit (110) zur Bildung eines ersten Multiturn-Codeworts (MC1) aus den ersten Positionssignalen (PS1),
- einer zweiten Abtasteinrichtung (140), mit der die wenigstens eine Teilungsspur (20, 30) zur Erzeugung von zweiten Positionssignalen (PS2) abtastbar ist,
- einer zweiten Singleturn-Auswerteeinheit (200) zur Bildung eines zweiten Singleturn-Codeworts (SC2) aus den zweiten Positionssignalen (PS2),
- einer zweiten Multiturn-Auswerteeinheit (210) zur Bildung eines zweiten Multiturn-Codeworts (MC2) aus den zweiten Positionssignalen (PS2),
- einer Batterie (320), mit der wenigstens die zur Bildung der Multiturn-Codewörter (MC1, MC2) erforderlichen Komponenten bei Ausfall einer Hauptstromversorgung (300) mit Energie versorgbar sind, **dadurch gekennzeichnet, dass**
- der Multiturn-Drehgeber eine erste Batterie-Überwachungseinheit (400) umfasst, mit der die Funktion der Batterie (320) überwachbar und durch wenigstens ein Batterie-Zustandssignal (BAT1, BAT2) anzeigbar ist,
und die erste Batterie-Überwachungseinheit (400) eine Kontinuitäts-Überwachungseinheit (450) umfasst, mit der die Kontinuität der Batteriespannung (V_{BAT}) der Batterie (320) überwachbar und durch ein zweites Batterie-Zustandssignal (BAT2) anzeigbar ist.

2. Multiturn-Drehgeber nach Anspruch 1, **dadurch gekennzeichnet, dass** die erste Batterie-Überwachungseinheit (400) eine Ladezustands-Überwachungseinheit (410) umfasst, mit der der Ladezustand der Batterie (320) feststellbar und durch ein erstes Batterie-Zustandssignal (BAT1) anzeigbar ist.

3. Multiturn-Drehgeber nach Anspruch 2, **dadurch gekennzeichnet, dass** der der Ladezustand der Batterie (320) durch Vergleich einer Batteriespannung (V_{BAT}) mit einer Referenzspannung (V_{REF}) in einer Vergleicher-Einheit (420) feststellbar ist.

4. Multiturn-Drehgeber nach einem der Ansprüche 2 oder 3, **dadurch gekennzeichnet, dass** der Ladezustands-Überwachungseinheit (410) ein erstes Testsignal (TEST1) zuführbar ist, das einen fehlerhaften Ladezustand der Batterie (320) künstlich erzeugt.

5. Multiturn-Drehgeber nach einem der vorhergehenden Ansprüche, **dadurch gekennzeichnet, dass** der Kontinuitäts-Überwachungseinheit (450) ein zweites Testsignal (TEST2) zuführbar ist, das eine Diskontinuität der Batteriespannung (V_{BAT}) künstlich verursacht.

6. Multiturn-Drehgeber nach einem der vorhergehenden Ansprüche, **dadurch gekennzeichnet, dass** eine Diskontinuität der Batteriespannung (V_{BAT}) eine Veränderung des Speicherinhalts einer Speichereinheit (460) bewirkt.

7. Multiturn-Drehgeber nach einem der vorhergehenden Ansprüche, **dadurch gekennzeichnet, dass** neben der ersten Batterie-Überwachungseinheit (400) eine redundante zweite Batterie-Überwachungseinheit (500) vorgesehen ist.

8. Verfahren zum Betreiben eines Multiturn-Drehgebers mit
- einer Maßverkörperung (10) mit mindestens einer Teilungsspur (20, 30), mittels derer die Winkelstellung einer Welle absolut codiert ist,
- einer ersten Abtasteinrichtung (40), mit der die wenigstens eine Teilungsspur (20, 30) zur Erzeugung von ersten Positionssignalen (PS1) abtastbar ist,
- einer ersten Singleturn-Auswerteeinheit (100) zur Bildung eines ersten Singleturn-Codeworts (SC1) aus den ersten Positionssignalen (PS1),
- einer ersten Multiturn-Auswerteeinheit (110) zur Bildung eines ersten Multiturn-Codeworts (MC1) aus den ersten Positionssignalen (PS1),
- einer zweiten Abtasteinrichtung (140), mit der die wenigstens eine Teilungsspur (20, 30) zur Erzeugung von zweiten Positionssignalen (PS2) abtastbar ist,
- einer zweiten Singleturn-Auswerteeinheit (200) zur Bildung eines zweiten Singleturn-Codeworts (SC2) aus den zweiten Positionssignalen (PS2),
- einer zweiten Multiturn-Auswerteeinheit (210) zur Bildung eines zweiten Multiturn-Codeworts (MC2) aus den zweiten Positionssignalen (PS2),
- einer Batterie (320), mit der wenigstens die zur Bildung der Multiturn-Codewörter (MC1, MC2) erforderlichen Komponenten bei Ausfall einer Hauptstromversorgung (300) mit Energie versorgbar sind, **dadurch gekennzeichnet, dass**
- der Multiturn-Drehgeber eine erste Batterie-Überwachungseinheit (400) umfasst, mit der die Funktion der Batterie (320) überwacht und durch wenigstens ein Batterie-Zustandssignal (BAT1, BAT2) angezeigt wird,
und die erste Batterie-Überwachungseinhe (400) weiter eine Kontinuitäts-Überwachungseinheit (450) umfasst, mit der die Kontinuität der Batteriespannung (V_{BAT}) der Batterie (320) überwacht und durch ein zweites Batterie-Zustandssignal (BAT2) anzeigt wird.

9. Verfahren nach Anspruch 8, **dadurch gekennzeichnet, dass** die erste Batterie-Überwachungseinheit (400) eine Ladezustands-Überwachungseinheit (410) umfasst, mit der der Ladezustand der Batterie (320) festgestellt und durch ein erstes Batterie-Zustandssignal (BAT1) angezeigt wird.

10. Verfahren nach Anspruch 9, **dadurch gekennzeichnet, dass** der der Ladezustand der Batterie (320) durch Vergleich einer Batteriespannung (V_{BAT}) mit einer Referenzspannung (V_{REF}) in einer Vergleicher-Einheit (420) festgestellt wird.

11. Verfahren nach einem der Ansprüche 9 oder 10, **dadurch gekennzeichnet, dass** der Ladezustands-Überwachungseinheit (410) ein erstes Testsignal (TEST1) zugeführt ist, mit dem ein fehlerhafter Ladezustand der Batterie (320) künstlich erzeugt wird.

12. Verfahren nach einem der Ansprüche 8 bis 11, **dadurch gekennzeichnet, dass** der Kontinuitäts-Überwachungseinheit (450) ein zweites Testsignal (TEST2) zugeführt ist, mit dem eine Diskontinuität der Batteriespannung (V_{BAT}) künstlich verursacht wird.

13. Verfahren nach einem der Ansprüche 8 bis 12, **dadurch gekennzeichnet, dass** durch eine Diskontinuität der Batteriespannung (V_{BAT}) eine Veränderung des Speicherinhalts einer Speichereinheit (460) bewirkt wird.

## Claims

1. Multi-turn rotary encoder having
- a material measure (10) with at least one graduation track (20, 30) which is used to code the angular position of a shaft in absolute terms,
- a first scanning device (40) which can be used to scan the at least one graduation track (20, 30) in order to generate first position signals (PS1),
- a first single-turn evaluation unit (100) for forming a first single-turn code word (SC1) from the first position signals (PS1),
- a first multi-turn evaluation unit (110) for forming a first multi-turn code word (MC1) from the first position signals (PS1),
- a second scanning device (140) which can be used to scan the at least one graduation track (20, 30) in order to generate second position signals (PS2),
- a second single-turn evaluation unit (200) for forming a second single-turn code word (SC2) from the second position signals (PS2),
- a second multi-turn evaluation unit (210) for forming a second multi-turn code word (MC2) from the second position signals (PS2),
- a battery (320) which can be used to supply at least the components needed to form the multi-turn code words (MC1, MC2) with energy if a main power supply (300) fails,
**characterized in that**
- the multi-turn rotary encoder comprises a first battery monitoring unit (400), with which the function of the battery (320) can be monitored and can be indicated by means of at least one battery state signal (BAT1, BAT2), and the first battery monitoring unit (400) comprises a continuity monitoring unit (450), with which the continuity of the battery voltage (V_{BAT}) of the battery (320) can be monitored and can be indicated by means of a second battery state signal (BAT2).

2. Multi-turn rotary encoder according to Claim 1, **characterized in that** the first battery monitoring unit (400) comprises a state of charge monitoring unit (410), with which the state of charge of the battery (320) can be determined and can be indicated by means of a first battery state signal (BAT1).

3. Multi-turn rotary encoder according to Claim 2, **characterized in that** the state of charge of the battery (320) can be determined by comparing a battery voltage (V_{BAT}) with a reference voltage (V_{REF}) in a comparator unit (420).

4. Multi--turn rotary encoder according to either of Claims 2 and 3, **characterized in that** a first test signal (TEST1) which artificially produces an incorrect state of charge of the battery (320) can be supplied to the state of charge monitoring unit (410).

5. Multi-turn rotary encoder according to one of the preceding claims, **characterized in that** a second test signal (TEST2) which artificially causes a discontinuity in the battery voltage (V_{BAT}) can be supplied to the continuity monitoring unit (450).

6. Multi-turn rotary encoder according to one of the preceding claims, **characterized in that** a discontinuity in the battery voltage (V_{BAT}) causes a change in the memory content of a memory unit (460).

7. Multi-turn rotary encoder according to one of the preceding claims, **characterized in that** a redundant second battery monitoring unit (500) is provided in addition to the first battery monitoring unit (400).

8. Method for operating a multi-turn rotary encoder having
- a material measure (10) with at least one graduation track (20, 30) which is used to code the angular position of a shaft in absolute terms,
- a first scanning device (40) which can be used to scan the at least one graduation track (20, 30) in order to generate first position signals (PS1),
- a first single-turn evaluation unit (100) for forming a first single-turn code word (SC1) from the first position signals (PS1),
- a first multi-turn evaluation unit (110) for forming a first multi-turn code word (MC1) from the first position signals (PS1),
- a second scanning device (140) which can be used to scan the at least one graduation track (20, 30) in order to generate second position signals (PS2),
- a second single-turn evaluation unit (200) for forming a second single-turn code word (SC2) from the second position signals (PS2),
- a second multi-turn evaluation unit (210) for forming a second multi-turn code word (MC2) from the second position signals (PS2),
- a battery (320) which can be used to supply at least the components needed to form the multi-turn code words (MC1, MC2) with energy if a main power supply (300) fails,
**characterized in that**
- the multi-turn rotary encoder comprises a first battery monitoring unit (400), with which the function of the battery (320) is monitored and is indicated by means of at least one battery state signal (BAT1, BAT2), and the first battery monitoring unit (400) also comprises a continuity monitoring unit (450), with which the continuity of the battery voltage (V_{BAT}) of the battery (320) is monitored and is indicated by means of a second battery state signal (BAT2).

9. Method according to Claim 8, **characterized in that** the first battery monitoring unit (400) comprises a state of charge monitoring unit (410), with which the state of charge of the battery (320) is determined and is indicated by means of a first battery state signal (BAT1).

10. Method according to Claim 9, **characterized in that** the state of charge of the battery (320) is determined by comparing a battery voltage (V_{BAT}) with a reference voltage (V_{REF}) in a comparator unit (420).

11. Method according to either of Claims 9 and 10, **characterized in that** a first test signal (TEST1) which artificially produces an incorrect state of charge of the battery (320) is supplied to the state of charge monitoring unit (410).

12. Method according to one of Claims 8 to 11, **characterized in that** a second test signal (TEST2) which artificially causes a discontinuity in the battery voltage (V_{BAT}) is supplied to the continuity monitoring unit (450).

13. Method according to one of Claims 8 to 12, **characterized in that** a discontinuity in the battery voltage (V_{BAT}) causes a change in the memory content of a memory unit (460).

## Revendications

1. Codeur rotatif à tours multiples comportant
- une échelle de mesure (10) ayant au moins une piste graduée (20, 30), au moyen de laquelle la position angulaire d'un arbre est codée de manière absolue,
- un premier dispositif de balayage (40) à l'aide duquel l'au moins une piste graduée (20, 30) peut être balayée pour générer des premiers signaux de position (PS1),
- une première unité d'évaluation de tour unique (100) destinée à former un premier mot de code de tour unique (SC1) à partir des premiers signaux de position (PS1),
- une première unité d'évaluation de tours multiples (110) destinée à former un premier mot de code de tours multiples (MC1) à partir des premiers signaux de position (PS2),
- un second dispositif de balayage (140) à l'aide duquel l'au moins une piste graduée (20, 30) peut être balayée pour générer des seconds signaux de position (PS2),
- une seconde unité d'évaluation de tour unique (200) destinée à former un second mot de code de tour unique (SC2) à partir des seconds signaux de position (PS2),
- une seconde unité d'évaluation de tours multiples (210) destinée à former un second mot de code de tours multiples (MC2) à partir des seconds signaux de position (PS2),
- une batterie (320) à l'aide de laquelle au moins les composants nécessaires à la formation des mots de code de tours multiples (MC1, MC2) peuvent être alimentés en énergie en cas de panne d'une alimentation électrique principale (300),
**caractérisé en ce que**
- le codeur rotatif à tours multiples comprend une première unité de surveillance de batterie (400) à l'aide de laquelle le fonctionnement de la batterie (320) peut être surveillé et peut être indiqué au moyen d'au moins un signal d'état de batterie (BAT1, BAT2),
et **en ce que** la première unité de surveillance de batterie (400) comprend une unité de surveillance de continuité (450) à l'aide de laquelle la continuité de la tension de batterie (V_{BAT}) de la batterie (320) peut être surveillée et peut être indiquée au moyen d'un second signal d'état de batterie (BAT2).

2. Codeur rotatif à tours multiples selon la revendication 1, **caractérisé en ce que** la première unité de surveillance de batterie (400) comprend une unité de surveillance d'état de charge (410) à l'aide de laquelle l'état de charge de la batterie (320) peut être déterminé et peut être indiqué au moyen d'un premier signal d'état de batterie (BAT1).

3. Codeur rotatif à tours multiples selon la revendication 2, **caractérisé en ce que** l'état de charge de la batterie (320) peut être déterminé par comparaison d'une tension de batterie (V_{BAT}) à une tension de référence (V_{REF}) dans une unité de comparaison (420).

4. Codeur rotatif à tours multiples selon l'une quelconque des revendications 2 ou 3, **caractérisé en ce qu'**un premier signal de test (TEST1) peut être délivré à l'unité de surveillance d'état de charge (410), qui génère artificiellement un état de charge erroné de la batterie (320).

5. Codeur rotatif à tours multiples selon l'une quelconque des revendications précédentes, **caractérisé en ce qu'**un second signal de test (TEST2) peut être délivré à l'unité de surveillance de continuité (450), qui provoque artificiellement une discontinuité de la tension de batterie (V_{BAT}),

6. Codeur rotatif à tours multiples selon l'une quelconque des revendications précédentes, **caractérisé en ce qu'**une discontinuité de la tension de batterie (V_{BAT}) produit une modification du contenu de mémoire d'une unité à mémoire (460).

7. Codeur rotatif à tours multiples selon l'une quelconque des revendications précédentes, **caractérisé en ce qu'**en plus de la première unité de surveillance de batterie (400), il est prévu une seconde unité de surveillance de batterie redondante (500).

8. Procédé de mise en fonctionnement d'un codeur rotatif à tours multiples comportant
- une échelle de mesure (10) ayant au moins une piste graduée (20, 30), au moyen de laquelle la position angulaire d'un arbre est codée de manière absolue,
- un premier dispositif de balayage (40) à l'aide duquel l'au moins une piste graduée (20, 30) peut être balayée pour générer des premiers signaux de position (PS1),
- une première unité d'évaluation de tour unique (100) destinée à former un premier mot de code de tour unique (SC1) à partir des premiers signaux de position (PS1),
- une première unité d'évaluation de tours multiples (110) destinée à former un premier mot de code de tours multiples (MC1) à partir des premiers signaux de position (PS1),
- un second dispositif de balayage (140) à l'aide duquel l'au moins une piste graduée (20, 30) peut être balayée pour générer des seconds signaux de position (PS2),
- une seconde unité d'évaluation de tour unique (200) destinée à former un second mot de code de tour unique (SC2) à partir des seconds signaux de position (PS2),
- une seconde unité d'évaluation de tours multiples (210) destinée à former un second mot de code de tours multiples (MC2) à partir des seconds signaux de position (PS2),
- une batterie (320) à l'aide de laquelle au moins les composants nécessaires à la formation des mots de code de tours multiples (MC1, MC2) peuvent être alimentés en énergie en cas de panne d'une alimentation électrique principale (300),
**caractérisé en ce que**
- le codeur rotatif à tours multiples comprend une première unité de surveillance de batterie (400) à l'aide de laquelle le fonctionnement de la batterie (320) est surveillé et est indiqué au moyen d'au moins un signal d'état de batterie (BAT1, BAT2),
et **en ce que** la première unité de surveillance de batterie (400) comprend en outre une unité de surveillance de continuité (450) à l'aide de laquelle la continuité de la tension de batterie (V_{BAT}) de la batterie (320) est surveillée et est indiquée au moyen d'un second signal d'état de batterie (BAT2).

9. Procédé selon la revendication 8, **caractérisé en ce que** la première unité de surveillance de batterie (400) comprend une unité de surveillance d'état de charge (410) à l'aide de laquelle l'état de charge de la batterie (320) est déterminé et est indiqué au moyen d'un premier signal d'état de batterie (BAT1).

10. Procédé selon la revendication 9, **caractérisé en ce que** l'état de charge de la batterie (320) est déterminé par comparaison d'une tension de batterie (V_{BAT}) à une tension de référence (V_{REF}) dans une unité de comparaison (420).

11. Procédé selon l'une quelconque des revendications 9 ou 10, **caractérisé en ce qu'**un premier signal de test (TEST1) est délivré à l'unité de surveillance d'état de charge (410), avec lequel un état de charge erroné de la batterie (320) est généré artificiellement.

12. Procédé selon l'une quelconque des revendications 8 à 11, **caractérisé en ce qu'**un second signal de test (TEST2) est délivré à l'unité de surveillance de continuité (450), avec lequel une discontinuité de la tension de batterie (V_{BAT}) est provoquée artificiellement.

13. Procédé selon l'une quelconque des revendications 8 à 12, **caractérisé en ce qu'**une discontinuité de la tension de batterie (V_{BAT}) produit une modification du contenu de mémoire d'une unité à mémoire (460).
